# EUROPEAN PATENT APPLICATION

(11) **EP 3 419 390 A1**
(43) Date of publication of application: **26.12.2018**
(21) Application number: 17177116.5
(22) Date of filing: 21.06.2017
(51) Int. Cl.: H05K 1/03, C04B 37/02, H05K 3/40, H05K 3/00

(54) **THICK-FILM PASTE MEDIATED CERAMICS BONDED WITH METAL OR METAL HYBRID FOILS AND VIAS**

(71) Applicant: Heraeus Deutschland GmbH & Co. KG, 63450 Hanau (DE)
(72) Inventor: Miric, Anton, 63755 Alzenau (DE); Rauer, Miriam, 63743 Aschaffenburg (DE); jung, Christian, 96173 Oberhaid (DE); Herbst, Kai, 61118 Bad Vilbel (DE); Dietrich, Peter, 63322 Rödermark (DE)
(74) Representative: Gille Hrabal

(57) **Abstract**

Described is a process for preparing a ceramic substrate bonded with a metal foil. Moreover, described is a metal-ceramic-substrate provided with a thick-film layer and the use of a thick-film paste for bonding a metal foil onto a ceramic substrate. The metal-ceramic-substrate according to the present invention are provided with at least one vertical via (via-hole) in the ceramic in order to allow circuit interconnections.

## Description

The present invention relates to a process for preparing a ceramic substrate bonded with a metal foil via a thick-film layer. Moreover, the present invention relates to a metal-ceramic-substrate provided with a specific thick-film layer between the ceramic substrate and the metal foil and the use of a thick-film paste for bonding a metal foil onto a ceramic substrate. The metal-ceramic-substrate according to the present invention are provided with at least one vertical via (via-hole) in the ceramic in order to allow circuit interconnections of one side of the ceramic substrate with the other side of the ceramic substrate.

In the field of power microelectronics applications in automotive, in particular for electric vehicles or hybrid vehicles, the use of electronic circuits with a high current carrying capacity and high durability are a high demand. For this purpose, the use of a highly conductive material with a high current carrying capacity, such as copper, is necessary. At the same time, the respective material should have a high capacity of heat dissipation (heat removal). Moreover, it is necessary that the respective material allow a suitable connection via a bond wire, has a good solderability, and should have the possibility of an oxidation protection by currentless plattings.

In the DCB technology, a copper foil is bonded onto a ceramic substrate with a eutectic melt. This process technology suffers from some disadvantages, such as a high amount of rejects, the creation of cavities between the ceramic substrate and the copper foil and the relatively low resistance against temperature changes (which leads to a delamination after some thermic cycles). A respective technology is described, for example, in DE 10 2010 025 313 A in which a mixture of the metal and an oxide of this metal is applied on a ceramic substrate which is then bonded via a DCB process. On the other hand, substrates, which are prepared based on the thick print technology, are also known. These substrates have the disadvantage of high production costs and low electronic and thermal conductivity caused by the porosity of the sintered layers.

Starting from this prior art situation, the present invention has firstly the object to provide a metal-ceramic substrate which avoids the above-mentioned disadvantages.

In a second aspect, the present invention should allow simple circuit interconnections of one side of the ceramic substrate with the other side of the ceramic substrate.

In a first aspect, these objects are solved by a process for preparing a structured metal-ceramic substrate, characterized by the following process steps:
(1.1) applying of a thick-film paste onto a ceramic substrate;
(1.2) applying of a metal foil onto the thick-film layer of the ceramic substrate; and
(1.3) bonding of the metal foil with the ceramic substrate via the thick-film layer.

In a second aspect of the present invention, the underlying objects are solved by a metal-ceramic substrate, comprising
(a) a ceramic substrate and, provided thereon,
(b) a metal-containing thick-film layer, and, provided thereon;
(c) a metal foil.

In this process respectively in this metal-ceramic substrate according to the present invention, the ceramic substrate is provided with at least one via (via-hole) which allows circuit interconnections of one side of the ceramic substrate to the other side of the ceramic substrate.

In the context of the invention, vias (via-holes) generally means a region of the ceramic substrate which penetrates this layer completely, that is to say from one surface side of the ceramic substrate to the other one of the ceramic substrate, and is made of a solid material and produces an electrical and/or thermal connection through the layer of the ceramic material (= electroconductive material).

Since the ceramic substrate is provided with a thick-film paste being usually applied by a printing step (as outlined in detail later), the vertical vias (via-holes) through the ceramic isolator can be provided in a simple manner.

According to the present invention, it has been found out further that based on the thick-film technology it is possible to provide a substrate for use in the field of power electronics in which a metal foil is bonded via a thick-film paste of a metal onto a ceramic substrate (such as Al₂O₃ ceramic, AIN ceramic or Si₃N₄ ceramic). The resulting metal-ceramic-substrates have a high conductivity and durability and can be produced with reduced costs.

At first, the above-mentioned process for preparing a structured metal-ceramic substrate is described. Thereby, the process according to the present invention can be carried out in two embodiments:

### First embodiment of the claimed process

In the process according to the first embodiment of the present invention, the thick-film paste is applied onto the ceramic substrate in the first process step.

### First aspect: Discontinuous application of the thick-film paste

In a first aspect of the claimed process, the thick-film paste can be applied onto the ceramic substrate discontinuously such that the thick-film paste is only applied on those parts of the ceramic substrate, which correspond to an intended electronic circuit of the final metal-ceramic substrate.

In this first aspect, the metal foil may be applied, thereafter, continuously over the whole thick-film layer of the ceramic substrate. After that, the metal foil is bonded with the ceramic substrate and then structured, for example by etching.

In this first aspect, the metal foil may also be applied discontinuously over the thick-film layer only on those parts of the ceramic substrate on which the thick-film paste is applied.

### Second aspect: Continuous application of the thick-film paste

In a further second aspect of the process according to the present invention, the thick-film paste is applied continuously onto the ceramic substrate.

In this second aspect, the metal foil may be applied continuously over the whole thick-film layer of the ceramic substrate and the metal foil and the thick-film layer are structured, for example, by etching after bonding.

In this second aspect, the metal foil may also be applied discontinuously only on those parts of the ceramic substrate which correspond to an intended electronic circuit of the final metal-ceramic substrate. In this case, the thick-film layer is structured, for example, by etching after bonding.

After applying the thick-film paste onto the ceramic substrate, the thick-film paste may be air-dried prior to applying the metal foil onto the thick-film layer.

After applying the thick-film paste onto the ceramic substrate, the thick-film paste may also be sintered prior to applying the metal foil. Such a sintering process can be carried out by a temperature of below 1025 °C. Preferably, the sintering process is carried out by a temperature in the range of from 300 to 1025 °C, more preferably in the range of from 600 to 1025 °C, more preferably in the range of from 900 to 1025 °C, more preferably in the range of from 900 to less than 1025 °C, more preferably in the range of from 900 to 1000 °C.

Sintering / firing the electroconductive paste removes organic components from the wet film and ensures a good bonding of the thick film copper to the substrate. In contrast to the standard DCB process, adhesion of the fired electroconductive film is established well below the Cu-O eutectic melting temperature. Bonding of bulk Cu foils to this fired electroconductive film is then carried out by a pure metal to metal sintering process. Accordingly, this process differs from the one described e.g in DE 10 2010 025 313 A.

After applying the thick-film paste onto the ceramic substrate, the thick-film paste may also be air-dried and sintered prior to applying the metal foil onto the thick-film layer. The sintering conditions are as described above.

The sintering process of the applied thick-film paste is usually carried out under an inert atmosphere, such as a nitrogen atmosphere.

### Second embodiment of the claimed process

In a further modified process for preparing a structured metal-ceramic substrate according to the second embodiment of the present invention, the modified claimed process comprises the following process steps:
(2.1) applying of a thick-film paste onto a metal foil;
(2.2) applying of a ceramic substrate onto the thick-film layer of the metal foil; and
(2.3) bonding the metal foil with the ceramic substrate via the thick-film layer.

In this modified process, the thick-film paste may be coated onto the metal foil substrate by screen printing.

After applying the thick-film paste onto the metal foil, the thick-film paste may be air-dried prior to applying the metal foil onto the ceramic.

In the modified process according to the present invention, the metal foil and the thick-film paste are structured by etching before or after bonding the metal foil onto the ceramic substrate via the thick-film layer.

### The following explanations are given for both embodiments of the claimed process:

The thick-film paste may be applied onto the substrate or the metal foil by multilayer printing. If a process step of multilayer coating is applied and the thick-film paste is applied onto a substrate, the first coating of the multilayer coating may be provided with lines for contacts.

In both processes for preparing a structured metal-ceramic substrate, i.e. the normal process and the modified process, the bonding steps (1.3) and/or (2.3) are carried out by firing. Usually, the firing is carried out at a temperature of between 750 and 1100 °C, more preferably of between 800 and 1085 °C. In these bonding steps the metal foil is bonded via the thick-film paste to the ceramic substrate basically not by applying the DCB process since the metal foil is in contact with the layer provided by the thick-film paste and not with the ceramic substrate.

The metal foil may be oxidized before bonding to the ceramic substrate via the thick-film layer in both embodiments of the processes according to the present invention. In another embodiment of the present invention the metal foil is not oxidized before bonding to the ceramic substrate via the thick-film layer.

In a further modification of the claimed processes according to both embodiments, the thick-film layer may be oxidized before bonding of the metal foil onto the ceramic substrate. In another embodiment of the present invention the thick-film layer is not oxidized before bonding of the metal foil onto the ceramic substrate.

The process steps (1.3) and/or (2.3) of bonding the metal foil onto the ceramic substrate provided with the thick-film layer may be carried out under pressure.

In both embodiments according to the present invention, the metal foil is preferably a copper foil.

In a further aspect of the present invention, the ceramic substrate may be selected from the group consisting of an Al₂O₃ ceramic, an AIN ceramic and a Si₃N₄ ceramic, whereby the ceramic substrate is provided with at least one vertical via (via-hole) in order to allow circuit interconnections of one side of ceramic substrate with the other side of the ceramic substrate.

The one or several via(s) in the ceramic substrate will allow a circuit interconnection between one side of ceramic substrate with the other side of the ceramic substrate since the via(s) is/are filled with an electroconductive material.

The vias (via-holes) can be formed in the ceramic substrate by, for example, laser drilling and filling an electroconductive material, for example a metallic material, into the vias.

The vias (via-holes) are generally provided before the thick-film paste is applied to the ceramic substrate, i.e. before carrying out steps (1.1) respectively (2.2).

This electroconductive material may comprise copper or silver.

In a first aspect of the present invention, this electroconductive material of the via(s) is provided by the thick-film paste used as the intermediate between the ceramic substrate and the metal foil. This material is described below (cf. chapter "Thick-film paste").

In a second aspect of the present invention, the copper paste for using the via filling can have a different composition from the paste used to mediate the cupper foil bonding. Especially the via fill paste can comprise additional fillers that control the shrinkage of the paste during the firing process like SiO₂.

The vias can have a circular cross-section. The vias may have lateral diameters in a range from 0.1 mm to 1 mm, in particular from 0.3 mm to 0.7 mm. In particular, the vias have a ratio of height to width in a range from 0.01 to 3, preferably in the range of 0.3 to 3.

According to an embodiment of the present invention, the vias may be filled completely or in part with the electroconducting material. The electroconducting material can be filled into the vias in such a way that the vias are not completely filled by the material, but instead the material only covers the walls of the vias with a thickness less than half the diameter of the vias. Preferably, the vias may be filled completely.

The metallization layer prepared from the thick-film paste is electrically connected with the via connections. In case the thick-film paste is provided only on one side of the ceramic substrate, the vias are connected on the other side with an alternative electrically conductive element.

### Thick-film paste

In the following, the thick-film paste, which can be used in the process according to both embodiments of the present invention, is described in more detail:
The thick-film paste used in the process according to the present invention (either in the normal process or in the modified process) may comprise copper as a metal and optionally Bi₂O₃.

The thick-film paste comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further embodiment of the present invention, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably 40 to less than 92 wt.-% copper, more preferably in an amount of from 70 to less than 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 20 wt.-%, more preferably 0 to 5 wt.-% of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles may have a median diameter (d₅₀) of less than 100 µm, more preferably less than 20 µm, most preferably less than 10 µm.

The metal-containing thick-film paste, preferably on the basis of copper, may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, Cu₂O, CuO and Li₂O.

As described already above, the metal-containing thick-film paste, preferably on the basis of copper, may comprise SiO₂.

After applying the thick-film paste either onto the ceramic substrate or onto the metal foil, the layer thickness is preferably of from 5 to 150 µm, more preferably of from 20 to 125 µm, most preferably of from 30 to 100 µm.

In a preferred embodiment of the present invention, the amount of copper oxide in the thick-film paste is less than 2 wt.-%, more preferably less than 1.9 wt.-%, more preferably less than 1.8 wt.-%, more preferably less than 1.5 wt.-%.

### Metal-ceramic substrate

In a further aspect, the present invention relates to a metal-ceramic substrate, comprising
(a) a ceramic substrate and, provided thereon,
(b) a metal-containing thick-film layer, and, provided thereon,
(c) a metal foil.

The metal foil and/or the metal-containing thick-film layer may be structured.

The thick-film layer, provided onto the ceramic substrate, comprises preferably copper as a metal and optionally Bi₂O₃.

The thick-film paste comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further embodiment of the present invention, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably in an amount of from 70 to 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.-%, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 urn.

In the case of use of a glass component in the thick-film paste, the glass component particles have may have a median diameter (d50) of less than 100 µm, more preferably less than 20 µm, most preferably less than 10 µm.

The metal-containing thick-film paste may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, Cu₂O, CuO and Li₂O.

The layer thickness of the thick-film paste is preferably 10 to 150 µm, more preferably 20 to 125 µm, most preferably 30 to 100 µm.

The metal foil is preferably a copper foil.

In a further aspect of the present invention, the ceramic may be selected from the group consisting of an Al₂O₃ ceramic, an AIN ceramic and a Si₃N₄ ceramic.

The metal-ceramic substrate according to the present invention may preferably be prepared according to the above-mentioned process.

In a further aspect, the present invention relates to the use of the above-mentioned thick-film paste for preparing a metal-ceramic substrate as intermediate layer between a ceramic substrate and a metal foil. The above-mentioned thick-film is used in order to avoid the delamination of the resulting system of a substrate and a metal foil during operation by thermal cycles.

The thick-film layer, provided onto the ceramic substrate, comprises preferably copper as a metal and optionally Bi₂O₃.

The thick-film paste comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further embodiment of the present invention, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably in an amount of from 70 to 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.-%, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles have may have a median diameter (d₅₀) of less than 100 µm, more preferably less than 20 µm, most preferably less than 10 µm.

The metal-containing thick-film paste may comprise - besides the glass component and Bi₂O₃ - further components, selected from the group consisting of PbO, TeO₂, Bi₂O₃, ZnO, B₂OP₃, Al₂O₃, TiO₂, CaO, K₂O, MgO, Na₂O, ZrO₂, Cu₂O, CuO and Lᵢ2O.

The layer thickness of the thick-film paste is preferably 10 to 150 µm, more preferably 20 to 125 µm, most preferably 30 to 100 µm.

The metal foil is preferably a copper foil.

The present invention is further shown by reference to the enclosed figures.

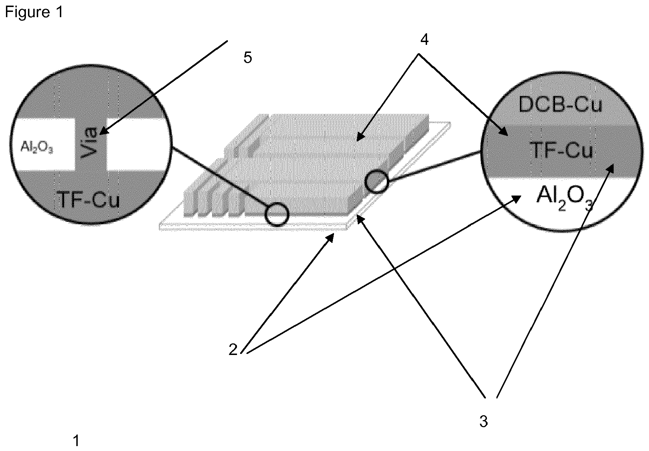

Figure 1 shows a DCB substrate 1 which a ceramic substrate 2. On the ceramic substrate 2 a thick-film paste 3 is provided. On this thick-film paste 3 a copper foil 4 is applied. In the ceramic substrate 2 a via 5 is provided.

The present invention is described in more detail with regard to the following examples:

### Examples

A thick-film paste material is prepared starting from the following glass composition (in wt.-%):

| Glass | d₅₀ (µm) | Tg (DSC, °C) | SiO₂ | ZnO | B₂O₃ | Al₂O₃ | TiO₂ | CaO | K₂O | MgO | Na₂O | ZrO₂ | Li₂O |
|---|---|---|---|---|---|---|---|---|---|---|---|---|---|
| A | 2,6 | 744 | 38 | 0.2 | 3.9 | 19.5 | 2.4 | 35.9 | 0.1 | 0 | 0 | 0.1 | 0 |
| B | 3,6 | 677 | 27.3 | 3.9 | 10.5 | 24.7 | 3.5 | 25.9 | 0 | 3.21 | 0.8 | 0 | 0 |
| C | 2,8 | 584.6 | 61.2 | 0.5 | 9.0 | 3.3 | 6.4 | 8.8 | 6.5 | 0.5 | 2.8 | 0 | 0.6 |

**Vehicle formulation**

| Texanol [wt%] | Butyl diglyme | Acrylic resin |
|---|---|---|
| 43 | 23 | 34 |

**Paste formulation**

| Paste | Cu powder [wt%] (d₅₀ of 4.7 µm) | Glass type; [wt%] | Vehicle [wt%] | Bi₂O₃ [wt%] (d₅₀ of 4.3 µm) |
|---|---|---|---|---|
| A | 86 | A; 3 | 11 | - |
| B | 86 | B; 3 | 11 | - |
| C | 86 | C; 3 | 11 | - |
| D | 86 | - | 11 | 3 |

Starting from these paste formulations, a ceramic metal substrate was prepared by printing the pastes on a Al₂O₃ ceramic substrate in a thickness of 40 µm. The pastes were dried in an oven at 110 °C for 10 min and sintered at 950°C for 10 minutes before a Cu foil with a thickness of 300 µm was applied onto the dried pastes and the composite was fired in an oven at 1040 °C for 150 min.

For comparison, a ceramic metal substrate was prepared starting from the same ceramic substrate and the same Cu foil as for the examples with pastes, but using a standard DCB process with a bonding time of 160 min and a peak temperature in the range of 1078 °C for 4 minutes. This ceramic substrate 4 comprises an area 4b for a power component 4 prepared by a classical DCB process. The Al₂O₃ ceramic substrate comprises a via which are prepared by a laser ablation of the ceramic substrate and filing the resulting hole having a diameter of about 400 µm with the same paste as described above.

The finished metal ceramic substrates have been subject to thermal cycles (15 min at -40 °C, 15 sec. transfer time, 15 min at +150 °C). The test results can be seen in the following table.

| Metal ceramic substrate | Paste | # of thermal cycles before delamination |
|---|---|---|
| 1 | A | 1550 |
| 2 | B | 2470 |
| 3 | C | 3040 |
| 4 | D | 2850 |
| 5 | No paste, standard DCB process | 100 |

## Claims

1. A process for preparing a structured metal-ceramic substrate, **characterized by** the following process steps:
(1.1) applying of a thick-film paste onto a ceramic substrate;
(1.2) applying of a metal foil onto the thick-film layer of the ceramic substrate; and
(1.3) bonding of the metal foil with the ceramic substrate via the thick-film layer;
**characterized in that**
the ceramic substrate comprises at least one vertical via (via-hole).

2. A process for preparing a structured metal-ceramic substrate, **characterized by** the following process steps:
(2.1) applying of a thick-film paste onto a metal foil;
(2.2) applying of a ceramic substrate onto the thick-film layer of the metal foil; and
(2.3) bonding the metal foil with the ceramic substrate via the thick-film layer;
**characterized in that**
the ceramic substrate comprises at least one vertical via (via-hole).

3. The process according to claim 1 or 2, **characterized in that** the vias are filled with an electroconductive material comprising copper and/or silver.

4. The process according to any one of claims 1 to 3, **characterized in that** the vias are formed in the ceramic substrate by laser drilling and filling an electroconductive material into the resulting holes before applying the thick-film paste onto the ceramic substrate in steps (1.1) or (2.2).

5. The process according to any of claims 1 to 4, **characterized in that** the vias have a circular cross-section and a lateral diameter in a range from 0.01 mm to 1 mm.

6. The process according to any one of claims 1 to 5, **characterized in that** the vias being filled completely or in part with the electroconducting material.

7. The process according to claim 6, **characterized in that** the electroconductive material is filled into the vias in such a way that the vias are not completely filled by the material and the electroconductive material only covers the walls of the vias with a thickness less than half the diameter of the vias.

8. The process according to any of claims 1 to 7, **characterized in that** the thick-film paste comprises copper as a metal and optionally Bi₂O₃.

9. The process according to any of claims 1 to 7, **characterized in that** the thick-film paste comprises copper as a metal and optionally a glass material.

10. The process according to claim 8 or 9, **characterized in that** the thick-film paste comprises copper in an amount of from 40 to 92 wt.-%, based on the total weight of the thick-film paste.

11. A metal-ceramic substrate, comprising
(a) a ceramic substrate and, provided thereon,
(b) a metal-containing thick-film layer, and, provided thereon;
(c) a metal foil;
**characterized in that**
the ceramic substrate comprises at least one vertical via (via-hole).

12. The metal-ceramic substrate according to claim 11, **characterized in that** the vias are filled with an electroconductive material comprising copper and/or silver.

13. The metal-ceramic substrate according to claim 11 or 12, **characterized in that** the vias have a circular cross-section and a lateral diameter in a range from 0.01 mm to 1 mm.

14. The metal-ceramic substrate according to anyone of claims 11 to 13, **characterized in that** the vias being filled completely or in part with the electroconducting material.

15. The metal-ceramic substrate according to claim 14, **characterized in that** the electroconductive material can be filled into the vias in such a way that the vias are not completely filled by the material and the electroconductive material only covers the walls of the vias with a thickness less than half the diameter of the vias.
